# EUROPEAN PATENT SPECIFICATION

(11) **EP 3 226 254 B1**
(45) Date of publication and mention of the grant of the patent: **16.09.2020**
(21) Application number: 17152764.1
(22) Date of filing: 24.01.2017
(51) Int. Cl.: H01B 7/18, H01B 3/44, H01B 7/28, H01B 7/282, H01B 7/04

(54) **FLUORORESIN CABLE AND ELECTRONIC DEVICE**
FLUORHARZKABEL UND ELEKTRONISCHE VORRICHTUNG
CÂBLE EN RÉSINE FLUORÉE ET DISPOSITIF ÉLECTRONIQUE

(30) Priority: 31.03.2016 JP 2016071206
(43) Date of publication of application: 04.10.2017
(73) Proprietor: Omron Corporation, Kyoto 600-8530 (JP)
(72) Inventor: KUME, Tsutomu, Kyoto-shi,, Kyoto 600-8530, (JP); INOUE, Daisuke, Kyoto-shi,, Kyoto 600-8530, (JP); NAKAMURA, Masaki, Kyoto-shi,, Kyoto 600-8530, (JP); USHIRO, Yuki, Kyoto-shi,, Kyoto 600-8530, (JP)
(74) Representative: Mewburn Ellis LLP

(56) References cited:
- EP-A1- 2 774 963
- EP-A2- 0 771 010
- EP-A2- 2 051 261
- CN-U- 202 905 245
- CN-U- 204 516 391
- JP-A- 2013 258 104

## Description

### BACKGROUND OF THE INVENTION

### Field of the Invention

The present disclosure relates to a fluororesin cable having a sheath made of a fluororesin, and an electronic device including a casing connected with the fluororesin cable.

### Description of the Background Art

In order to increase oil resistance or chemical resistance of an electronic device, a fluororesin cable is often used as a cable to be connected with a casing of the electronic device. In this case, it is necessary to seal between the fluororesin cable and the casing to prevent entrance of a chemical and the like into the casing.

For example, a detection switch disclosed in Japanese Utility Model Laying-Open No. 1-170929 (Patent Document 1) includes a tubular case made of a fluororesin which is open at one end, a lid body made of a fluororesin for closing the opening of the case, and a cable having a tip connected with a sensing element and a sheath made of a fluororesin. The lid body is welded to the cable in a state where the cable penetrates therethrough in the vicinity of the sensing element. The tubular case is provided in a state where the sensing element is inserted therein, and is sealed with the lid body welded to the opening.

Document CN 202905245 U discloses a fluororesin cable comprising an inclusion made of thermoplastic elastomer, TPE, and a fluoroplastic external sheath layer.

### SUMMARY OF THE INVENTION

What is often problematic in the fluororesin cable is that the cable itself tends to be hard and thus it is difficult to route the cable. In the case of the fluororesin cable described in Patent Document 1 described above, since the cable has a coaxial structure in which a net wire is provided around the outer periphery of a core wire with an insulator being interposed therebetween as shown in its first drawing, the cable has an insufficient flexibility and cannot be easily routed.

In contrast, when a cable structure not provided with a net wire is adopted and a highly soft material is used as a sheath material, the cable has an improved flexibility but it may be difficult to prevent generation of a gap between a casing and the cable. The inventors of the present application have obtained the above finding during the process of completing the invention of the present application. For example, when the cable is too soft, a sealing member may fail to be properly welded to the sheath.

The present disclosure takes the aforementioned problem into consideration, and a main object thereof is to provide a fluororesin cable which can be easily routed for wiring and can improve a close contact with a casing of an electronic device. According to the invention, a fluororesin cable is provided as defined in claim 1. Further developments of the invention are the subject of the dependent claims.

A fluororesin cable in accordance with one aspect of the present disclosure includes at least one electric wire having a central conductor covered with an insulator, at least one inclusion, a tape made of a resin, and a sheath made of a fluororesin. The at least one inclusion is arranged along the at least one electric wire. The tape is wound around an outer periphery of an aggregate of the at least one electric wire and the at least one inclusion. The sheath entirely covers the aggregate and the tape. Here, a material for the at least one inclusion is harder than a fluororesin material constituting the sheath.

By adopting a material harder than the fluororesin material consisting the sheath as the material for the inclusion as described above, the hardness of the entire cable can be maintained at an appropriate value even when a relatively soft material is used as the fluororesin material. As a result, a fluororesin cable which can be easily routed for wiring and can improve a close contact with a casing of an electronic device can be provided.

Preferably, the sheath has a thickness of more than or equal to 0.3 mm and less than or equal to 1.05 mm. By setting the thickness of the sheath to more than or equal to 0.3 mm as described above, permeation of an oil from the outside to the inside of the cable can be suppressed. By setting the thickness of the sheath to less than or equal to 1.05 mm, the flexibility of the cable can be prevented from being impaired.

In one preferable embodiment, the at least one inclusion is rod-shaped. In another preferable embodiment, the fluororesin cable includes a plurality of inclusions as the at least one inclusion. The plurality of inclusions are a plurality of bundled cord-shaped inclusions, and are provided around the at least one electric wire.

An electronic device in accordance with another aspect of the present disclosure includes a casing, a circuit board embedded in the casing, and the fluororesin cable. The sheath of the fluororesin cable is fixed to the casing with a sealing member being interposed therebetween. Each central conductor of the fluororesin cable is electrically connected with the circuit board.

The sealing member may be made of a resin welded to the sheath of the fluororesin cable or made of a resin formed on the sheath by injection molding. In this case, it is preferable that the at least one inclusion of the fluororesin cable is rod-shaped.

The sealing member may include a bush or an O ring. In this case, it is preferable that the fluororesin cable includes a plurality of inclusions as the at least one inclusion, which are a plurality of bundled cord-shaped inclusions, and are provided around the at least one electric wire.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic cross sectional view showing a configuration of a fluororesin cable.
Fig. 2 is a schematic cross sectional view showing another exemplary configuration of the fluororesin cable of Fig. 1.
Fig. 3 is a flowchart showing one exemplary process for manufacturing the fluororesin cable.
Fig. 4 is a perspective view showing an external appearance of an electronic device as a first specific example.
Fig. 5 is an enlarged view of a connection portion between a casing and a cable in Fig. 4.
Fig. 6 is a schematic perspective view of the cable in Fig. 4 and a sealing member fixed thereto.
Fig. 7 is a partial cross sectional view showing a connection portion between a casing of an electronic device and a cable as a second specific example.
Fig. 8 is an exploded perspective view of the connection portion in Fig. 7.
Fig. 9 is an exploded perspective view showing a connection portion between a casing of an electronic device and a cable as a third specific example.
Fig. 10 is a schematic cross sectional view of the connection portion in Fig. 9.

### DESCRIPTION OF THE PREFERRED EMBODIMENTS

Hereinafter, an embodiment will be described in detail with reference to the drawings. It should be noted that identical or corresponding parts will be designated by the same reference numerals, and the description thereof will not be repeated.

### [Structure of Fluororesin Cable]

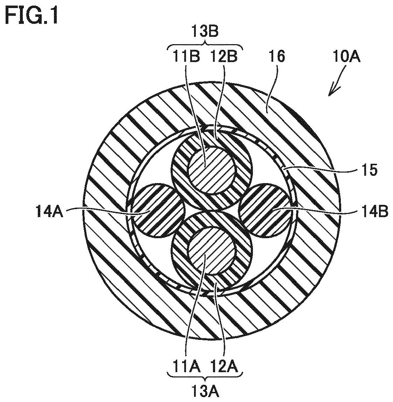

Fig. 1 is a schematic cross sectional view showing a configuration of a fluororesin cable. Referring to Fig. 1, a fluororesin cable 10A includes at least one electric wire 13A, 13B, at least one inclusion 14A, 14B, a tape 15, and a sheath 16. Fig. 1 shows an example of cable 10A including two electric wires 13A, 13B and two inclusions 14A, 14B. Hereinafter, when electric wires 13A, 13B and inclusions 14A, 14B are each collectively referred to, or when any of electric wires 13A, 13B and any of inclusions 14A, 14B are each referred to, they will be described as an electric wire 13 and an inclusion 14, respectively.

Electric wire 13A has a structure in which a central conductor 11A is covered with an insulator 12A. Similarly, electric wire 13B has a structure in which a central conductor 11B is covered with an insulator 12B. When central conductors 11A, 11B and insulators 12A, 12B are each collectively referred to, or when any of central conductors 11A, 11B and any of insulators 12A, 12B are each referred to, they will be described as a central conductor 11 and an insulator 12, respectively.

Although central conductor 11 may be a single wire made of a metal (for example, copper), central conductor 11 is preferably a stranded wire in order to increase the flexibility of cable 10A. Insulator 12 is formed by extrusion-molding a synthetic resin material such as polyethylene (PE), polyvinyl chloride (PVC), or a fluororesin, for example.

Inclusion 14 is a rod-shaped resin member arranged along a longitudinal direction of electric wire 13. Although inclusion 14 is stranded with electric wire 13 each other in the case of the present embodiment, inclusion 14 does not necessarily have to be stranded with electric wire 13. In the case of Fig. 1, electric wires 13 and inclusions 14 are provided in the same number (two for each), they each have a circular cross sectional shape, and the diameter of inclusion 14 is smaller than the diameter of electric wire 13 (in the case of Fig. 1, the diameter of inclusion 14 is two-thirds of the diameter of electric wire 13). Inclusion 14 is formed using a synthetic resin such as polypropylene (PP) or polyamide (PA) (also called nylon), for example.

By providing inclusion 14, unevenness of the surface of cable 10A can be reduced, and cable 10A can have a substantially circular cross sectional shape. Further, tensile strength of cable 10A can be increased. Furthermore, the present embodiment is characterized in that hardness of cable 10A itself is adjusted by selecting a material for inclusion 14 (the characteristic will be described later in detail).

Tape 15 is wound around the outer periphery of an aggregate of electric wires 13 and inclusions 14. Hereinafter, tape 15 will also be referred to as press winding tape 15. Press winding tape 15 is formed using a synthetic resin such as polyethylene (PE), polyester (PEs), or a fluororesin. It should be noted that the fluororesin cable of Fig. 1 is not provided with a shield in order to increase flexibility.

By providing press winding tape 15, unevenness of the surface of cable 10A can be reduced, and cable 10A can have a substantially circular cross sectional shape. Further, peeling of sheath 16 for exposing central conductor 11 is facilitated.

Sheath 16 is formed for example by extrusion molding to entirely cover the aggregate and press winding tape 15. Sheath 16 is formed using a fluororesin material in order to increase oil resistance. As the fluororesin material, THV (a thermoplastic fluororesin made of three types of monomers including tetrafluoroethylene (T), hexafluoropropylene (H), and vinylidene fluoride (V)), which is a relatively soft material, or the like is used.

Exemplary dimensions of the components of the cable of Fig. 1 are as follows: central conductor 11 has a diameter of 0.58 mm, electric wire 13 has a diameter of 0.89 mm, sheath 16 has a thickness of 0.88 mm, and cable 10A has an overall diameter of 3.8 mm.

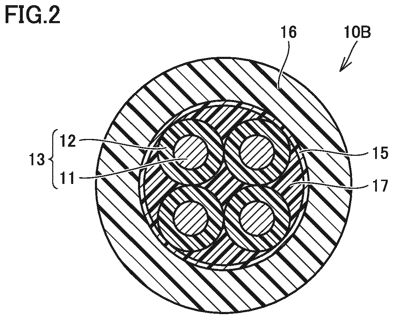

Fig. 2 is a schematic cross sectional view showing another exemplary configuration of the fluororesin cable of Fig. 1. A fluororesin cable 10B of Fig. 2 is different from fluororesin cable 10A of Fig. 1 in the number of electric wires 13 and the structure of inclusions 17.

Specifically, referring to Fig. 2, four electric wires 13 are provided in fluororesin cable 10B, and these electric wires 13 may be or may not be stranded with each other. Further, inclusions 17 are a number of bundled cord-shaped resin materials (synthetic fibers), and bundles of these cord-shaped inclusions 17 are provided around electric wires 13. Cord-shaped inclusion 17 is formed using a synthetic fiber such as polypropylene (PP) or polyamide (PA) (also called nylon), for example.

Exemplary dimensions of the components of the cable of Fig. 2 are as follows: central conductor 11 has a diameter of 0.58 mm, electric wire 13 has a diameter of 1.16 mm, sheath 16 has a thickness of 0.5 mm, and cable 10B has an overall diameter of 4.0 mm.

Since other components in Fig. 2 are the same as those in Fig. 1, identical or corresponding parts will be designated by the same reference numerals, and the description thereof will not be repeated. When fluororesin cable 10A of Fig. 1 and fluororesin cable 10B of Fig. 2 are collectively referred to in the following description, they will be described as a fluororesin cable 10.

### [Measure for Oil Resistance]

The present disclosure mainly assumes a case where fluororesin cable 10 described above is used in an industrial device such as a machine tool. For example, various electronic devices such as a limit switch, a proximity sensor, and a photoelectric sensor are attached to the machine tool. Since a cutting oil often splashes onto these electronic devices and cables connected to these electronic devices, oil resistance of each electronic device including fluororesin cable 10 is an issue. What is particularly an issue in this case is oil resistance of a connection portion between a casing of the electronic device and the cable.

Improving a close contact between the casing of the electronic device and cable 10 is important to increase oil resistance. For this purpose, it is necessary to make the cross sectional shape of cable 10 closer to a circular shape, and eliminate unevenness of the surface of sheath 16. For this reason, inclusions 14, 17 and tape 15 are provided, as already described.

Furthermore, the inventors of the present application have found that hardness of cable 10 itself is closely related to the close contact between the casing and cable 10. This is because, when the cable has an insufficient hardness, cable 10 is flattened by an external force, and thus the close contact between cable 10 and the casing is worsened and cable 10 may fall out of the casing (that is, shortage of tensile strength).

Here, hardness refers to a degree of deformation of a test object when a local force (concentrated load) is applied onto the test object from the outside for a short period of time. Generally, a method of measuring indentation hardness is used to measure hardness. Specifically, a depth of a dent (indentation amount) formed in a test surface when an indenter is pressed against the test object with a constant pressure is measured. In the Japanese Industrial Standards (JIS), such a method is defined for example as the Rockwell hardness test method (K7202) or a durometer hardness test method (K6253, K7215). It should be noted that the international standard corresponding to JIS K7202 is ISO 2039-2:1987. The international standards corresponding to JIS K6253 are ISO 18517:2005, ISO 18898:2006, ISO 48:2010, ISO 7619-1:2010, and ISO 7619-2:2010. The international standard corresponding to JIS K7215 is ISO/DIS 868.

Although the hardness of the cable and the flexibility (bending property) of the cable exhibit different mechanical characteristics (the external force is applied differently), they are related because the flexibility is obviously worsened when the cable is too hard. Accordingly, in order to facilitate routing of the cable and improve the close contact between the casing of the electronic device and the cable, there is a range appropriate for the hardness of the cable. For example, when a relatively soft material such as THV is used as the fluororesin material used for sheath 16 in order to maintain the flexibility of the cable, the hardness of inclusions 14, 17 should be higher than the hardness of sheath 16 in order to cause the cable to have a hardness within the appropriate range.

Generally, when fluororesin cable 10 is connected with the casing of the electronic device, they are connected with a sealing member made of a resin or a metal being interposed therebetween. When the sealing member made of a resin is welded to sheath 16 of cable 10 or when the sealing member made of a resin is formed on sheath 16 by injection molding, if cable 10 is too soft, it is not possible to bring the sealing member into proper close contact with sheath 16. Furthermore, in order to prevent transfer of a pressing force when the sealing member is joined to sheath 16, it is more desirable to use, as the inclusions of cable 10, rod-shaped inclusions 14 as shown in Fig. 1 than a number of cord-shaped inclusions 17 in Fig. 2. Further, when cable 10 has a too-small outer shape, a pressure may fail to be fully applied to the surface of sheath 16.

In contrast, when a rubber bush, an aluminum bush, or an O ring is used as the sealing member, a close contact between the sealing member and sheath 16 can be increased by reducing unevenness of the surface and making the cross sectional shape of cable 10 closer to a circular shape as much as possible. Accordingly, in this case, it is more desirable to use, as the inclusions of cable 10, a number of cord-shaped inclusions 17 shown in Fig. 2 than rod-shaped inclusions 14 shown in Fig. 1, because cord-shaped inclusions 17 can make the cross sectional shape of cable 10 further closer to a circular shape.

Oil resistance of the fluororesin cable itself should also be considered. It is desirable that sheath 16 of cable 10 has a thickness within a range of more than or equal to 0.3 mm and less than or equal to 1.05 mm. In order to maintain oil-resistant performance of cable 10 by preventing permeation of the cutting oil into cable 10, it is desirable that sheath 16 has a thickness of more than or equal to 0.3 mm. In addition, since the flexibility of cable 10 is worsened when sheath 16 is too thick (which makes routing of the cable difficult), the upper limit of the thickness of sheath 16 is set to 1.05 mm.

### [Process for Manufacturing Fluororesin Cable]

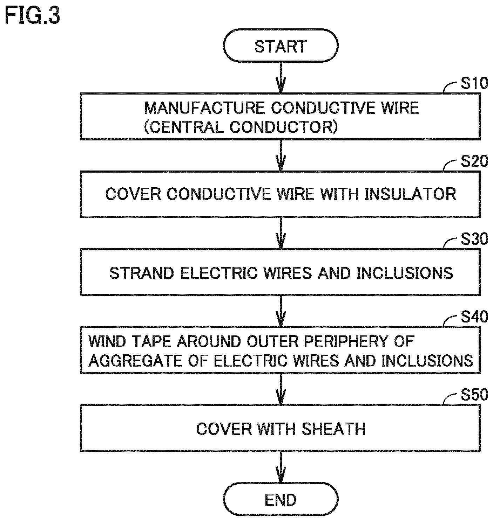

Fig. 3 is a flowchart showing one exemplary process for manufacturing the fluororesin cable. Fluororesin cables 10 of Figs. 1 and 2 can be fabricated using a well-known manufacturing method. Hereinafter, one exemplary process for manufacturing the cable of Fig. 1 will be briefly described.

Referring to Figs. 1 and 3, first, conductive wire (central conductor) 11 is manufactured (step S10). In this case, a single conductive wire may be manufactured by drawing a wire rod, or a stranded wire may be manufactured by stranding a number of fine conductive wires.

Next, conductive wire 11 is covered with insulator 12 by extrusion molding (step S20). Thereby, electric wire 13 is manufactured.

Next, electric wires 13 and inclusions 14 are stranded (step S30), and press winding tape 15 is wound around electric wires 13 and inclusions 14 (step S40). Then, covering with sheath 16 is performed by extrusion molding (step S50).

### [Example of Connection of Cable - Welding, Resin Sealing]

Hereinafter, specific examples of a method for connecting the casing of the electronic device and fluororesin cable 10 will be described. In any of the following cases, cable 10 should have an appropriate hardness in order to establish a close contact between the casing and cable 10.

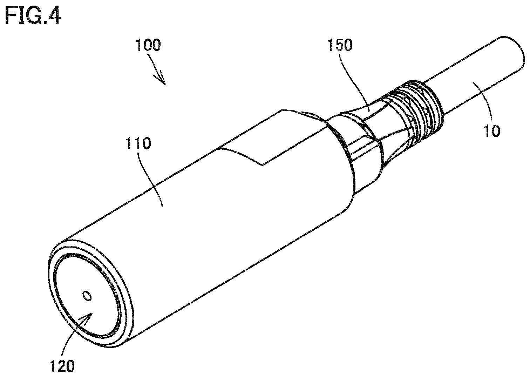

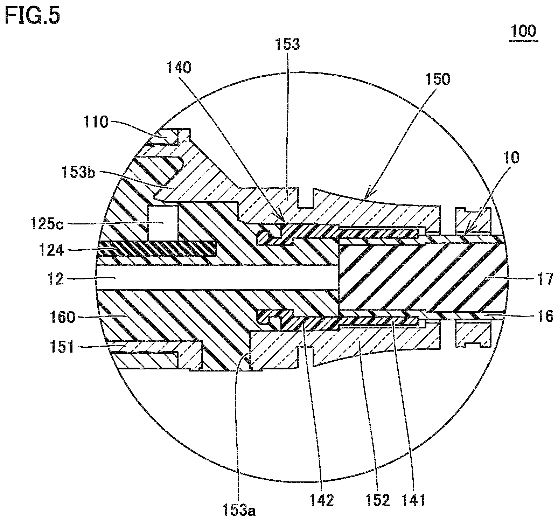

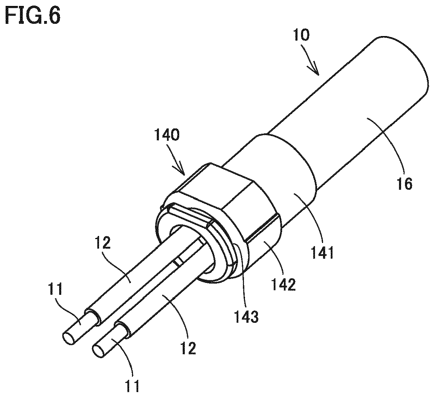

Fig. 4 is a perspective view showing an external appearance of an electronic device as a first specific example. Fig. 5 is an enlarged view of a connection portion between a casing and a cable in Fig. 4. Fig. 6 is a schematic perspective view of the cable in Fig. 4 and a sealing member fixed thereto.

Referring to Figs. 4 to 6, a proximity sensor 100 as the electronic device in the first specific example has a substantially cylindrical outer shape, and includes a casing 110, a sensor assembly 120, cable 10, a sealing member 140, a clamp 150, and a sealing resin portion 160.

Casing 110 is constituted by a long cylindrical member made of a metal which is open at both ends, and has a front end portion and a rear end portion in an axial direction. Sensor assembly 120 is assembled to the front end portion of casing 110, and clamp 150 is assembled to the rear end portion of casing 110. Sensor assembly 120 includes a core and a sensing coil which are housed in a coil case.

A circuit board 124 having various processing circuits formed thereon is arranged to extend along the axial direction of casing 110. Circuit board 124 has front and back surfaces having electric conductive patterns formed thereon, and various electronic components (a light emitting element 125c as an example) are mounted at predetermined positions on the front and back surfaces. Further, the sensing coil described above is electrically connected to circuit board 124.

Cable 10 is arranged to be inserted through an opening on the rear end side provided to casing 110. At one end of cable 10, insulator 12 and sheath 16 are peeled such that central conductor 11 is exposed, and central conductor 11 is electrically connected to circuit board 124. The other end of cable 10 is routed out of casing 110.

Sealing member 140 is a member for securing joining between cable 10 and sealing resin portion 160, and is assembled to an end portion of sheath 16 located on the one end side of cable 10.

Sealing member 140 has a cylindrical base portion 141 which covers an outer peripheral surface of the end portion of sheath 16 located on the one end side of cable 10 in an internal space defined by casing 110 and clamp 150, and a tubular extending portion 142 which extends toward the one end side of cable 10 more than the end portion of sheath 16 located on the one end side of cable 10. Sealing member 140 is attached to cable 10 such that at least a portion of sealing member 140 enters the internal space defined by casing 110 and clamp 150. Base portion 141 is welded to the surface of sheath 16 of cable 10.

Extending portion 142 is, in more detail, located on the one end side of cable 10 more than the end portion of sheath 16 located on the one end side of cable 10, and protrudes to extend along a direction in which cable 10 extends. Tubular extending portion 142 includes a relatively thick portion located on a base side thereof, and a portion configured to have a sufficiently thin thickness located on a tip side thereof. It should be noted that sealing member 140 is made of a resin, and is more suitably made of any of a PBT resin, a PUR resin, a nylon-based resin, and a fluorine-based resin.

Clamp 150 has a substantially cylindrical shape, and cable 10 is inserted thereinto. Clamp 150 is fitted into the opening on the rear end side provided to casing 110, and sealing member 140 described above is fitted into a rear end portion of clamp 150, thereby holding cable 10. Clamp 150 is constituted by a member made of a resin to be elastically deformable, and is provided to relieve stress applied to cable 10 and stress applied to sealing member 140.

In more detail, clamp 150 includes a cylindrical fixing portion 151 located at a front end portion, a substantially cylindrical holding portion 152 located at the rear end portion, and a connection portion 153 located between fixing portion 151 and holding portion 152 for connecting fixing portion 151 and holding portion 152.

Fixing portion 151 is a portion for fixing clamp 150 to casing 110 by being press-fitted into the opening on the rear end side provided to casing 110. Holding portion 152 is a portion for holding sealing member 140 by sealing member 140 being press-fitted thereinto. In addition, connection portion 153 is a portion for improving the function of relieving the stress applied to cable 10 and the stress applied to sealing member 140 described above by securing a predetermined distance between fixing portion 151 and holding portion 152.

Further, in order to fill the internal space defined by casing 110 and clamp 150 with sealing resin portion 160, a gate 153a used when injecting a liquid resin serving as sealing resin portion 160 is provided at a predetermined position of connection portion 153.

It should be noted that, in the present embodiment, clamp 150 is made of a non-light-shielding resin material, in order to project light emitted from light emitting element 125c described above to the outside through clamp 150. Accordingly, a light guiding portion 153b having a predetermined shape is provided at a portion of fixing portion 151 facing the light emitting element.

Sealing resin portion 160 fills the internal space defined by casing 110 and clamp 150. Thereby, a portion of circuit board 124 except for a front end portion, various electronic components (including light emitting element 125c) mounted on that portion, and a portion of cable 10 which is not covered with sheath 16 are sealed with sealing resin portion 160.

Sealing resin portion 160 protects the portion of circuit board 124 except for the front end portion, the various electronic components (including light emitting element 125c) mounted on that portion, and central conductor 11 at the portion of cable 10 which is not covered with sheath 16, and seals them from the outside in an airtight and liquid-tight manner.

As described above, sealing resin portion 160 is formed by injecting the liquid resin through gate 153a in clamp 150 and curing the liquid resin. As a material for sealing resin portion 160, for example, an epoxy resin, a PUR resin, or the like can be suitably used.

Here, extending portion 142 of sealing member 140 is joined to sealing resin portion 160, and, at a portion of extending portion 142 on the tip side, all of an inner peripheral surface thereof, an outer peripheral surface thereof, and an end surface on the tip side in an axial direction thereof are covered with sealing resin portion 160. Thereby, in electronic device (proximity sensor) 100, a joining force between cable 10 and sealing resin portion 160 is secured to be higher than that of a conventional proximity sensor.

In the above description, sealing member 140 or the whole of sealing member 140 and clamp 150 can also be formed by injection molding.

### [Example of Connection of Cable - Bush, Resin Sealing]

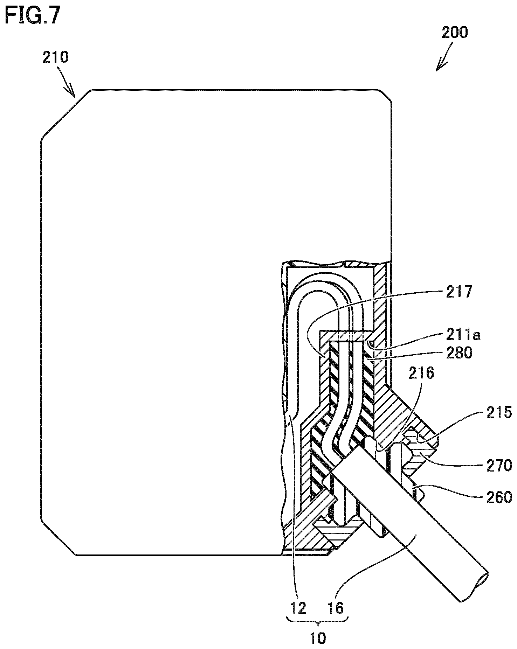

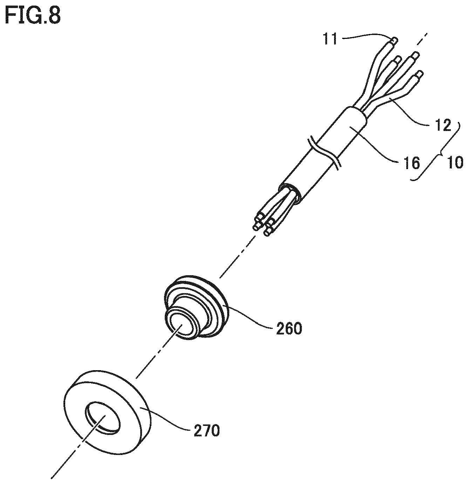

Fig. 7 is a partial cross sectional view showing a connection portion between a casing of an electronic device and a cable as a second specific example. Fig. 8 is an exploded perspective view of the connection portion in Fig. 7.

Referring to Figs. 7 and 8, a photoelectric sensor 200 as the electronic device in the second specific example has a casing 210 made of a metal having a shape of a substantially rectangular parallelepiped as a whole.

As shown in Fig. 7, a recessed portion 215 which is circular in a plan view is provided in the vicinity of a region where the back surface and the lower surface of casing 210 cross. The bottom surface of recessed portion 215 is provided with a cable insertion opening 216 to establish communication between an internal space of casing 210 and an external space of casing 210. Cable insertion opening 216 also has a circular shape in a plan view.

Cable 10 is arranged to be inserted through cable insertion opening 216. One end thereof is routed into casing 210 and is electrically connected to an internal circuit board (not shown), and the other end thereof is routed out of casing 210. At the one end of cable 10 described above, sheath 16 is peeled such that insulator 12 of electric wire 13 is exposed. Further, at a portion connected to the circuit board, insulator 12 of electric wire 13 is also peeled such that central conductor 11 is exposed.

A bush 260 having a tubular shape is attached at a predetermined position of cable 10. Bush 260 is constituted by a member made of a rubber, for example, and suitably made of any of a nitrile rubber (NBR), a hydrogenated nitrile rubber (HNBR), and a fluorine-based rubber. It should be noted that the bush is not limited to the one made of a rubber, and various bushes such as the one made of a plastic can be used as long as the bush can seal a gap between cable 10 and casing 210.

Further, a fixing member 270 having an annular shape is fitted into recessed portion 215 of casing 210, and thereby cable 10 is fixed to casing 210. Fixing member 270 is constituted by a member made of a metal, for example, and suitably made of brass. Bush 260, with being attached to cable 10, is press-fitted into cable insertion opening 216 together with cable 10, and fixing member 270 is further press-fitted into recessed portion 215 to compress bush 260. Thereby, bush 260 establishes a close contact with cable 10 and casing 210, and thus the internal space of casing 210 is sealed from the external space of casing 210 at that portion.

In addition, in photoelectric sensor 200 in Fig. 7, a partition wall portion 217 is provided in the internal space of casing 210, at a position facing cable insertion opening 216. Partition wall portion 217 is provided to stand from an inner surface of casing 210. This partition wall portion 217 and a wall portion of casing 210 in the vicinity of a portion provided with cable insertion opening 216 form a cable insertion chamber 211a in which a predetermined portion of cable 10 is inserted and arranged.

In cable insertion chamber 211a, a portion of cable 10 which is routed into casing 210 through cable insertion opening 216 is arranged. This cable insertion chamber 211a, in which the predetermined portion of cable 10 is inserted and arranged, is filled with a sealing resin portion 280. Sealing resin portion 280 is made of a resin material which has a high weather resistance after being cured, and for example, an epoxy resin, a urethane resin, or an epoxy resin or a urethane resin of the type which foams after filling can be suitably used. It should be noted that sealing resin portion 280 can be formed, for example, by fixing cable 10 to casing 210 and thereafter pouring a liquid resin material into cable insertion chamber 211a and curing the resin material.

With the above configuration, in addition to a sealing structure using bush 260 and fixing member 270, a boundary portion between cable 10 and casing 210 is covered with sealing resin portion 280 at a position on a more inner side of casing 210 than a portion where bush 260 is arranged. As a result, at that portion, a portion of the internal space of casing 210 except for cable insertion chamber 211a is reliably sealed from the external space of casing 210.

### [Example of Connection of Cable - O Ring]

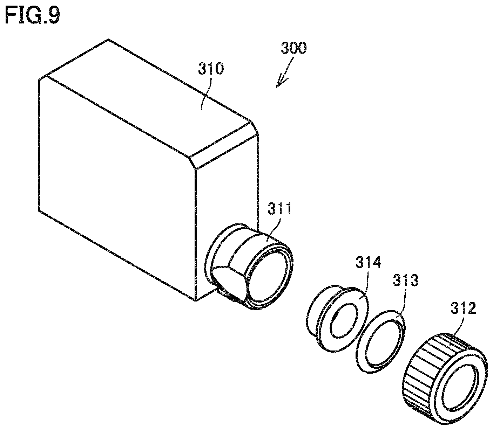

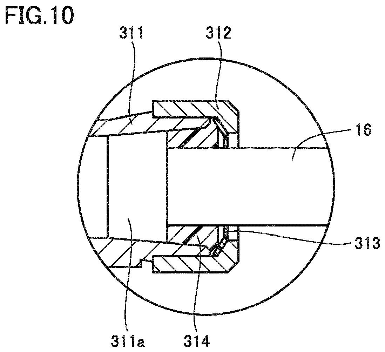

Fig. 9 is an exploded perspective view showing a connection portion between a casing of an electronic device and a cable as a third specific example. Fig. 10 is a schematic cross sectional view of the connection portion in Fig. 9.

Referring to Figs. 9 and 10, a switch 300 as the electronic device in the third specific example has a casing 310 made of a metal having a shape of a substantially rectangular parallelepiped as a whole. A cylindrical protruding portion 311 is provided at a lower portion of a side surface of casing 310, through which cable 10 can be inserted into an internal space of casing 310.

At a predetermined position of cable 10, a seal rubber 314, an O ring 313, and a cap 312 having cylindrical shapes are attached in this order such that cable 10 is inserted therethrough. Although seal rubber 314 and O ring 313 are constituted by members made of a rubber, various resin materials can be used as long as they can seal a gap between cable 10 and casing 310. Cap 312 is constituted by a member made of a metal, for example, and suitably made of brass. Cap 312 can be screwed onto protruding portion 311 of casing 310.

By screwing cap 312 onto protruding portion 311 with seal rubber 314, O ring 313, and cap 312 being attached to cable 10, O ring 313 presses down seal rubber 314. As a result, seal rubber 314 contracts in an axial direction of cable 10 and expands in a direction perpendicular to the axial direction, and thus the gap between casing 310 and cable 10 is sealed via seal rubber 314.

### [Effect]

As has been described above, according to the embodiment described above, by adopting a material harder than the fluororesin material consisting sheath 16 as the material for inclusion 14 of fluororesin cable 10, the hardness of the entire cable can be maintained at an appropriate value even when a relatively soft material is used as the fluororesin material for sheath 16. Further, by setting the thickness of sheath 16 to more than or equal to 0.3 mm, permeation of the oil from the outside to the inside of cable 10 can be suppressed. By setting the thickness of the sheath to less than or equal to 1.05 mm, the flexibility of the cable can be prevented from being impaired. As a result, both the oil resistance of the electronic device and the flexibility of the cable can be achieved.

Although the embodiment of the present invention has been described, it should be understood that the embodiment disclosed herein is illustrative and non-restrictive in every respect. The scope of the present invention is defined by the scope of the claims, and is intended to include any modifications within the scope and meaning equivalent to the scope of the claims.

## Claims

1. A fluororesin cable, comprising:
at least one electric wire (13) having a central conductor (11) covered with an insulator (12);
at least one inclusion (14; 17) made of a resin material arranged along the at least one electric wire (13);
a tape (15) made of a resin wound around an outer periphery of an aggregate of the at least one electric wire (13) and the at least one inclusion (14; 17); and
a sheath (16) made of a fluororesin material entirely covering the aggregate and the tape (15);
**characterized in that**:
the resin material for the at least one inclusion (14; 17) is harder than the fluororesin material constituting the sheath (16), based on a Rockwell hardness test method or a durometer hardness test method.

2. The fluororesin cable according to claim 1, wherein the sheath (16) has a thickness of more than or equal to 0.3 mm and less than or equal to 1.05 mm.

3. The fluororesin cable according to claim 1 or 2, wherein the at least one inclusion (14) is rod-shaped.

4. The fluororesin cable according to claim 1 or 2, wherein the fluororesin cable comprises a plurality of inclusions as the at least one inclusion (17), and the plurality of inclusions are a plurality of bundled cord-shaped inclusions, and are provided around the at least one electric wire (13).

5. An electronic device, comprising:
a casing (110; 210; 310);
a circuit board (124) embedded in the casing (110; 210; 310); and
the fluororesin cable (10) according to any one of claims 1 to 4,
the sheath (16) of the fluororesin cable (10) being fixed to the casing (110) with a sealing member (140; 260, 280; 313, 314) being interposed therebetween,
each central conductor (11) of the fluororesin cable (10) being electrically connected with the circuit board (124).

6. The electronic device according to claim 5, wherein
the at least one inclusion (14) of the fluororesin cable (10) is rod-shaped, and
the sealing member (140) is made of a resin welded to the sheath (16) of the fluororesin cable (10) or made of a resin formed on the sheath (16) by injection molding.

7. The electronic device according to claim 5, wherein
the fluororesin cable (10) includes a plurality of inclusions as the at least one inclusion (17),
the plurality of inclusions are a plurality of bundled cord-shaped inclusions, and are provided around the at least one electric wire (13), and
the sealing member includes a bush (260) or an O ring (313).

## Patentansprüche

1. Fluorharzkabel, das Folgendes umfasst:
zumindest eine elektrische Leitung (13), die einen zentralen Leiter (11) aufweist, der mit einem Isolationsmaterial (12) bedeckt ist;
zumindest einen Einschluss (14; 17) bestehend aus einem Harzmaterial, das entlang der zumindest einen elektrischen Leitung (13) angeordnet ist;
ein Band (15) bestehend aus einem Harz, das um einen Außenumfang eines Aggregats aus der zumindest einen elektrischen Leitung (13) und dem zumindest einen Einschluss (14; 17) gewickelt ist; und
einen Mantel (16) bestehend aus einem Fluorharzmaterial, der das Aggregat und das Band (15) vollständig bedeckt;
**dadurch gekennzeichnet, dass**:
gemäß einem Rockwell-Härtetestverfahren oder einem Durometerhärtetestverfahren das Harzmaterial für den zumindest einen Einschluss (14; 17) härter ist als das Fluorharzmaterial, das den Mantel (16) bildet.

2. Fluorharzkabel nach Anspruch 1, wobei der Mantel (16) eine Dicke von größer oder gleich 0,3 mm und kleiner oder gleich 1,05 mm aufweist.

3. Fluorharzkabel nach Anspruch 1 oder 2, wobei der zumindest eine Einschluss (14) stabförmig ist.

4. Fluorharzkabel nach Anspruch 1 oder 2, wobei das Fluorharzkabel eine Vielzahl von Einschlüssen als den zumindest einen Einschluss (17) umfasst und
die Vielzahl von Einschlüssen eine Vielzahl gebündelter schnurförmiger Einschlüsse ist und die um die zumindest eine elektrische Leitung (13) herum bereitgestellt sind.

5. Elektronische Vorrichtung, die Folgendes umfasst:
ein Gehäuse (110; 210; 310);
eine Leiterplatte (124), die in das Gehäuse (110; 210; 310) eingebettet ist; und
das Fluorharzkabel (10) nach einem der Ansprüche 1 bis 4,
wobei der Mantel (16) des Fluorharzkabels (10) an dem Gehäuse (110) mittels eines Dichtungselements (140; 260, 280; 313, 314) befestigt ist, das zwischen diesen angeordnet ist,
wobei jeder zentrale Leiter (11) des Fluorharzkabels (10) mit der Leiterplatte (124) elektrisch verbunden ist.

6. Elektronische Vorrichtung nach Anspruch 5, wobei
der zumindest eine Einschluss (14) des Fluorharzkabels (10) stabförmig ist und
das Dichtungselement (140) aus einem Harz besteht, das an den Mantel (16) des Fluorharzkabels (10) geschweißt ist, oder aus einem Harz besteht, das durch Spritzformen auf dem Mantel (16) ausgebildet ist.

7. Elektronische Vorrichtung nach Anspruch 5, wobei
das Fluorharzkabel (10) eine Vielzahl von Einschlüssen als den zumindest einen Einschluss (17) umfasst,
die Vielzahl von Einschlüssen eine Vielzahl gebündelter schnurförmiger Einschlüsse ist und die um die zumindest eine elektrische Leitung (13) herum bereitgestellt sind, und
das Dichtungselement eine Buchse (260) oder einen O-Ring (313) umfasst.

## Revendications

1. Câble en résine fluorée, comprenant :
au moins un fil électrique (13) ayant un conducteur central (11) recouvert d'un isolant (12) ;
au moins un ajout (14 ; 17) constitué d'un matériau en résine agencé le long du au moins un fil électrique (13) ;
un ruban (15) constitué d'une résine enroulé autour d'une périphérie externe d'un agrégat du au moins un fil électrique (13) et du au moins un ajout (14 ; 17) ; et
une gaine (16) constituée d'un matériau de résine fluorée recouvrant entièrement l'agrégat et le ruban (15) ;
**caractérisé en ce que** :
le matériau de résine pour le au moins un ajout (14 ; 17) est plus dur que le matériau de résine fluorée constituant la gaine (16), sur la base d'un procédé de test de dureté Rockwell ou d'un procédé de test de dureté au duromètre.

2. Câble en résine fluorée selon la revendication 1, dans lequel la gaine (16) a une épaisseur supérieure ou égale à 0,3 mm et inférieure ou égale à 1,05 mm.

3. Câble en résine fluorée selon la revendication 1 ou 2, dans lequel le au moins un ajout (14) est en forme de tige.

4. Câble en résine fluorée selon la revendication 1 ou 2, dans lequel
le câble en résine fluorée comprend une pluralité d'ajouts identiques au au moins un ajout (17), et
la pluralité d'ajouts sont une pluralité d'ajouts en forme de cordon groupés, et sont prévus autour du au moins un fil électrique (13).

5. Dispositif électronique, comprenant :
un boîtier (110 ; 210 ; 310) ;
une carte de circuit imprimé (124) intégrée dans le boîtier (110 ; 210 ; 310) ; et
le câble en résine fluorée (10) selon l'une quelconque des revendications 1 à 4,
la gaine (16) du câble en résine fluorée (10) étant fixée au boîtier (110) avec un élément d'étanchéité (140 ; 260, 280 ; 313, 314) interposé entre eux,
chaque conducteur central (11) du câble en résine fluorée (10) étant connecté électriquement à la carte de circuit imprimé (124).

6. Dispositif électronique selon la revendication 5, dans lequel
le au moins un ajout (14) du câble en résine fluorée (10) est en forme de tige, et
l'élément d'étanchéité (140) est constitué d'une résine soudée à la gaine (16) du câble en résine fluorée (10) ou constitué d'une résine formée sur la gaine (16) par moulage par injection.

7. Dispositif électronique selon la revendication 5, dans lequel
le câble en résine fluorée (10) comprend une pluralité d'ajouts identiques au au moins un ajout (17), et
la pluralité d'ajouts sont une pluralité d'ajouts en forme de cordon groupés, et sont prévus autour du au moins un fil électrique (13), et
l'élément d'étanchéité comprend une douille (260) ou un joint torique (313).
